(19)

Europäisches
Patentamt

European
Patent Office

Office européen
des brevets

(11) **EP 2 980 912 B1**

(12) **EUROPEAN PATENT SPECIFICATION**

(45) Date of publication and mention
of the grant of the patent:
**14.03.2018 Bulletin 2018/11**

(21) Application number: **14775401.4**

(22) Date of filing: **27.01.2014**

(51) Int Cl.:
*H01M 10/42* (2006.01)    *H01M 10/48* (2006.01)
*G01R 31/36* (2006.01)    *H04B 7/24* (2006.01)
*H04Q 9/00* (2006.01)

(86) International application number:
**PCT/JP2014/051613**

(87) International publication number:
**WO 2014/156264 (02.10.2014 Gazette 2014/40)**

(54) **BATTERY SYSTEM**

BATTERIESYSTEM

SYSTÈME DE BATTERIES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.03.2013 JP 2013073181**

(43) Date of publication of application:
**03.02.2016 Bulletin 2016/05**

(73) Proprietor: **Hitachi Automotive Systems, Ltd.
Hitachinaka-shi, Ibaraki 312-8503 (JP)**

(72) Inventors:
• **YAMAZOE Takanori**
  **Tokyo 100-8280 (JP)**
• **IWASAWA Hiroshi**
  **Tokyo 100-8280 (JP)**
• **TERADA Takahide**
  **Tokyo 100-8280 (JP)**
• **TAKEUCHI Takashi**
  **Tokyo 100-8280 (JP)**
• **KIKUCHI Mutsumi**
  **Hitachinaka-shi,**
  **Ibaraki 312-8505 (JP)**
• **KUDO Akihiko**
  **Hitachinaka-shi,**
  **Ibaraki 312-8505 (JP)**
• **KANAI Tomonori**
  **Hitachinaka-shi,**
  **Ibaraki 312-8505 (JP)**

(74) Representative: **MERH-IP Matias Erny Reichl
Hoffmann
Patentanwälte PartG mbB
Paul-Heyse-Strasse 29
80336 München (DE)**

(56) References cited:
EP-A1- 2 778 697    EP-A2- 1 769 426
WO-A1-2012/061262    JP-A- 2007 141 464
JP-A- 2007 225 614    JP-A- 2007 504 537
JP-A- 2008 220 074    US-A1- 2007 182 576

## Description

### TECHNICAL FIELD

The present invention relates to a battery system.

### BACKGROUND ART

Currently, as concerns about the global environment have been increased, it is required to reduce emission of carbon dioxide gas in order to prevent global warming. For example, the substitution from vehicle with gasoline engine which is a main emission source of carbon dioxide gas to hybrid electric vehicle or electric vehicle begins. Typical large secondary battery as a driving power supply of hybrid electric vehicle or electric vehicle is required to have a high output and a high capacity. Therefore, storage battery module constituting a driving power supply is generally constructed of a plurality of battery cells connected in series and parallel.

Lithium ion battery is widely known as high-capacity secondary battery. In handling the lithium ion battery, measures for preventing high-voltage charging, measures for preventing performance degradation due to over-discharging, and the like are required. Thus, storage battery module, constructed of lithium ion batteries used for battery cells, that is mounted on hybrid electric vehicle or electric vehicle generally have a function of monitoring battery states such as voltage, current, temperature, and the like for each battery cell.

As the devices for monitoring the states of the battery cells as described above, a state monitoring device disclosed in the following Patent Literature 1, for example, is known. In the state monitoring device, an inductive-coupled RFID installed in a module for measuring voltage values of the battery cells transmits the voltage values of the battery cells to a reading device in a form of wireless signal. In this way, cost required for wiring and insulation is reduced.

In US 2007/182576 A1 a battery information collection system for collecting information on one or more batteries in use at a first site is described. The system comprises a data collection unit associated with each of the one or more batteries. The data collection unit including a sensor coupled to the battery associated therewith and a transmitter for sending battery operating data to a receiver.

In WO 2012/061262 A1 a wireless battery area network permits the wirelessly monitoring and controlling of individual batteries with large-scale battery applications.

In EP 1 769 426 A2 a radio frequency transponder includes at least one battery which is coupled to provide electrical power for operating the transponder and at least one antenna which is configured to receive and backscatter RF interrogation radiation from an interrogation device.

### CITATION LIST

#### PATENT LITERATURE

Patent Literature 1: Japanese Laid-Open Patent Publication No. 2005-135762

### SUMMARY OF INVENTION

#### TECHNICAL PROBLEM

The inductive-coupled RFID used in the state monitoring device described above has generally short communication distance of the order of several centimeters to several tens of centimeters. Therefore, as flexibility in layout of the RFID and the reading device is small, the configuration of the device.

Thus, it is a main object of the present invention to extend communication distance in a battery system that transmits the states of the battery cells by wireless communication.

#### SOLUTION TO PROBLEM

To solve the problems the features of the independent claim are suggested. Preferred developments are in the dependent claims.

#### ADVANTAGEOUS EFFECTS OF INVENTION

According to the present invention, the communication distance can be extended in the battery system that transmits the states of the battery cells by wireless communication.

#### BRIEF DESCRIPTION OF DRAWINGS

[FIG. 1] A figure illustrating a configuration of an in-vehicle system including a battery system in accordance with one embodiment of the present invention

[FIG. 2] A basic configuration figure of the battery system in accordance with a first embodiment of the present invention

[FIG. 3] A figure for explaining a method of wireless transmission from the battery controller to the cell controller

[FIG. 4] A figure for explaining a method of wireless transmission from the cell controller to the battery controller

[FIG. 5] A basic configuration figure of a battery system in accordance with a second embodiment of the present invention

[FIG. 6] A basic configuration figure of a battery system in accordance with a third embodiment of the present invention.

## DESCRIPTION OF EMBODIMENTS

(First Embodiment)

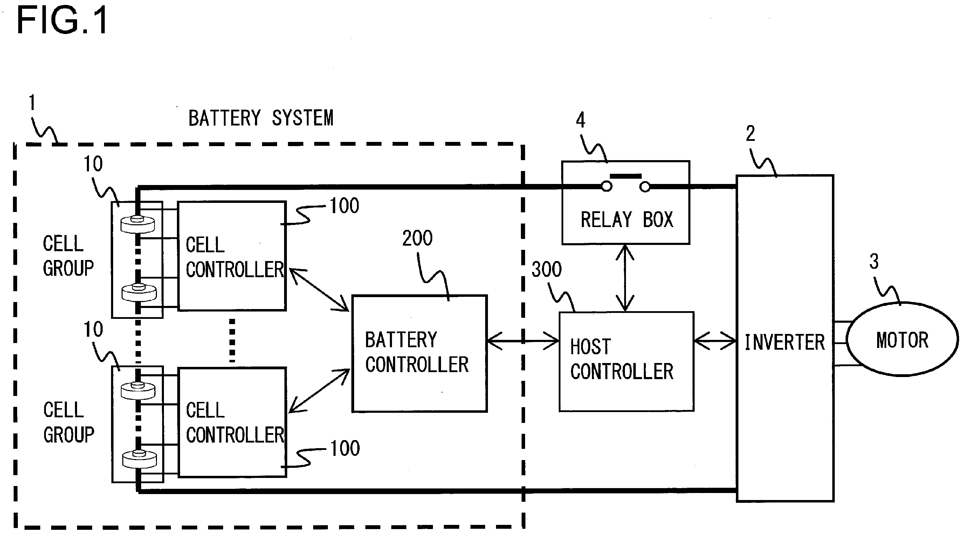

FIG. 1 is a figure illustrating a configuration of an in-vehicle system including a battery system in accordance with one embodiment of the present invention. The in-vehicle system illustrated in FIG. 1 is adapted to be mounted in a vehicle, such as a hybrid electric vehicle or an electric vehicle, and includes a battery system 1, an inverter 2, a motor 3, a relay box 4, and a host controller 300.

The battery system 1 is provided with a plurality of cell groups 10, each of which being constructed of a plurality of battery cells, and cell controllers 100 are installed to each cell group 10. Each cell controller 100 measures states (e.g. voltage, current, and temperature) of the battery cells in the cell group 10. The cell controllers 100 wirelessly transmit the results of the measurement of the states of the battery cells in the cell group 10 to the battery controller 200 through performing wireless communication with a battery controller 200 by using electric power supplied from the battery cells in the cell group 10. The wireless communication performed in this case will be described in detail hereinafter.

The battery controller 200 obtains, from each cell controller 100, the results of the measurement of the states of the battery cells in the cell group 10 which corresponds to the cell controller 100. Then, the battery controller 200 estimates SOC (State of Charge) and SOH (State of Health) of the battery cells on the basis of the obtained results of the measurement of the states of the battery cells and transmits estimation result to the host controller 300.

The host controller 300 controls the inverter 2 and the relay box 4 on the basis of the estimation result of the SOC and SOH of the battery cells transmitted from the battery controller 200. When the relay box 4 is in a conducting state, the inverter 2 causes the motor 3 to rotate and generate a driving force of the vehicle, by converting a DC power supplied from each cell group 10 to a three-phase AC power and supplying the power to the motor 3. Furthermore, during braking of the vehicle, the inverter 2 charges the battery cells in each cell group 10, by converting a three-phase AC regenerative power generated by the motor 3 to a DC power and outputting the power to each cell group 10. The aforementioned operation of the inverter 2 is controlled by the host controller 300.

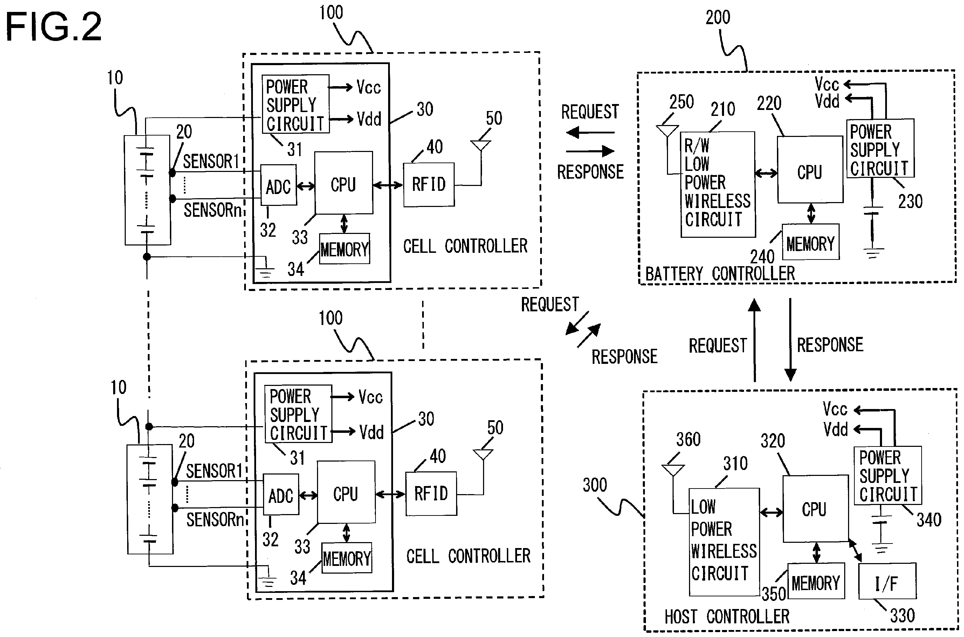

FIG. 2 is a basic configuration figure of the battery system in accordance with a first embodiment of the present invention. In this basic configuration figure, the cell groups 10, the cell controllers 100, the battery controller 200, and the host controller 300 are illustrated as basic components among the components of the in-vehicle system illustrated in FIG. 1.

In FIG. 2, the battery controller 200 performs wireless communication with each cell controller 100. Via this wireless communication, the battery controller 200 can request each cell controller 100 to transmit measurement information of the battery cells in the corresponding cell group 10 and to execute cell balancing operation, and the like. In response to the request from the battery controller 200, each cell controller 100 transmits the measurement information of the battery cells in the corresponding cell group 10 to the battery controller 200 or executes the cell balancing operation.

The host controller 300 performs wireless communication with the battery controller 200. Via this wireless communication, the host controller 300 can request the battery controller 200 to estimate the SOC or SOH of the battery cells. In response to the request from the host controller 300, the battery controller 200 estimates the SOC or SOH of the battery cells on the basis of the measurement information of the battery cells in the cell group 10 transmitted from each cell controller 100 and transmits the results to the host controller 300.

In the wireless communication between the battery controller 200 and each cell controller 100, a wireless scheme having a relatively short communication distance (of the order of several meters) with so-called semi-passive RFID is used. On the other hand, in the wireless communication between the host controller 300 and the battery controller 200, a wireless scheme having a relatively long communication distance (of the order of several hundred meters) so-called low power wireless communication is used. For this low power wireless communication, wireless schemes such as IEEE802.15.4 or the like may be used.

Each cell controller 100 includes a plurality of sensors 20, each of which being provided for each battery cell in the respective cell group 10, a processing unit 30, a RFID circuit 40, and an antenna 50. The processing unit 30 is constructed of a power supply circuit 31, an AD converter 32, a CPU 33, and a memory 34. Each sensor 20 is a sensor for measuring the state of each battery cell in the cell group 10 and includes a voltage sensor, a current sensor, a temperature sensor, or the like. The measurement result of the state of each battery cell by the sensor 20 is converted into digital signal by the AD converter 32 and is output as measurement information to the CPU 33. The sensor 20 and the AD converter 32 constitute a measurement circuit that measures the state of each battery cell in the cell group 10.

The power supply circuit 31 receives an electric power supplied from the battery cells in the cell group 10 and generates power source voltages Vcc and Vdd on the basis of the electric power. The power source voltage Vcc is used as an operating power source of the AD converter 32 and the CPU 33, while the power source voltage Vdd is used as an operating power source of the RFID circuit 40. It will be noted that the power supply circuit 31 can receive an electric power from at least one battery cell among the battery cells constituting the cell group 10.

The CPU 33 executes a processing for controlling the operation of the cell controller 100. For example, the CPU 33 causes the memory 34 to store the measurement information of each battery cell output from the AD converter 32 and the CPU 33 also performs a transmission processing for wirelessly transmitting the measurement information stored in the memory 34 to the battery controller 200, in response to the request from the battery controller 200. In this transmission processing, the CPU 33 controls the RFID circuit 40 depending on the measurement information read out from the memory 34 in order to change an impedance of the antenna 50 for the wireless signal transmitted from the battery controller 200. As a result, the CPU 33 transmits the measurement information according to the state of each battery cell to the battery controller 200, as a reflective wave for the wireless signal from the battery controller 200. This will be explained in detail hereinafter. Furthermore, when a balancing request is transmitted from the battery controller 200, the CPU 33 controls a balancing switch (not shown) to perform a balancing processing for making the SOCs of the battery cells in the cell group 10 uniform. Besides the processing described above, a variety of processing can be executed by the CPU 33.

The RFID circuit 40 is a wireless communication circuit for causing the cell controller 100 to operate as a semi-passive RFID. The wireless signal transmitted from the battery controller 200 and received by the antenna 50 is demodulated by the RFID circuit 40 and is output to the CPU 33. Due to this, the request from the battery controller 200 is decoded by the CPU 33 so that a processing according to the request is executed in the CPU 33. Furthermore, the RFID circuit 40 changes the impedance of the antenna 50 for the wireless signal from the battery controller 200 by using the power source voltage Vdd at a timing according to a predetermined communication rate, in dependence on the measurement information to be transmitted. As a result, the measurement information according to the state of each battery cell in the cell groups 10 is transmitted from the cell controller 100 to the battery controller 200, as a reflective wave for the wireless signal transmitted from the battery controller 200. The operation of the RFID circuit 40 in this process will be described in detail hereinafter.

The battery controller 200 includes a read/write (R/W) circuit 210, a CPU 220, a power supply circuit 230, a memory 240, and an antenna 250. The power supply circuit 230 generates power source voltages Vcc and Vdd on the basis of an electric power supplied from a battery built in the battery controller 200, in the same manner as the power supply circuit 31 of the cell controller 100. It will be noted that external power supply may be used, instead of the battery built in the battery controller 200.

The CPU 220 controls the operations of the read/write circuit 210 and the memory 240. The read/write circuit 210 operates in response to the control of the CPU 220 and performs wireless communication with the cell controller 100 and the host controller 300 via the antenna 250. The read/write circuit 210 has both the wireless communication function with the semi-passive RFID described above and the low power wireless communication function, and may selectively use one of these functions depending on the communication partner.

The host controller 300 includes a low power wireless circuit 310, a CPU 320, an interface circuit 330, a power supply circuit 340, a memory 350, and an antenna 360. The power supply circuit 340 generates power source voltages Vcc and Vdd on the basis of an electric power supplied from a battery built in the host controller 300, in the same manner as the power supply circuit 230 of the battery controller 200.

The CPU 320 controls the operations of the low power wireless circuit 310, the interface circuit 330, and the memory 350. The low power supply circuit 310 operates in response to the control of the CPU 320 and performs the low power wireless type of wireless communication with the battery controller 200 via the antenna 360. The interface circuit 330 performs interface processing of data communication interface between the host controller 300 and external devices (for example, the inverter 2 in FG. 1).

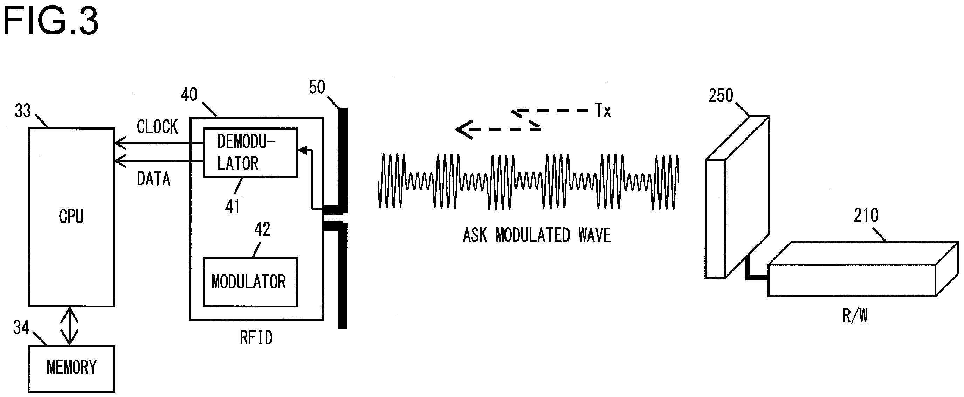

The wireless communication performed between the cell controller 100 and the battery controller 200 will now be described. FIG. 3 is a figure for explaining a method of wireless transmission from the battery controller 200 to the cell controller 100.

When the wireless transmission from the battery controller 200 to the cell controller 100 is performed, the battery controller 200 transmits an ASK modulated wave, in which the amplitude of a carrier wave frequency is changed in response to transmitted data, from the read/write circuit 210 to the cell controller 100 via an antenna 250, as illustrated in FIG. 3. The ASK modulated wave is received by the antenna 50 in the cell controller 100 and demodulated by a demodulator 41 in the RFID circuit 40. The demodulator 41 reproduces a clock and data by demodulating the received ASK modulated wave and outputs them as received data to the CPU 33. The received data is stored in the memory 34 by the CPU 33 and read is out as required.

Although the example with the ASK modulated wave has been described in FIG. 3, other modulation schemes may be used. For example, a PSK modulated wave may be used, in which the phase of the carrier wave frequency is changed in response to the transmitted data, or a combined modulation scheme involving both the ASK modulated wave and the PSK modulated wave may be used.

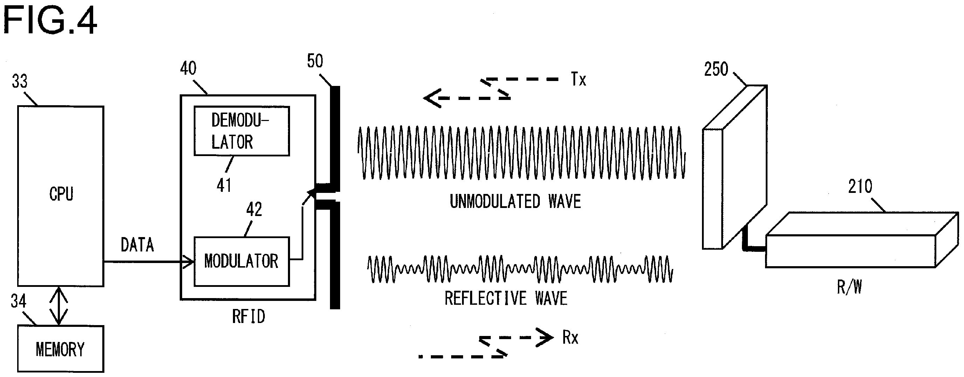

FIG. 4 is a figure for explaining a method of wireless transmission from the cell controller 100 to the battery controller 200.

When the wireless transmission from the battery controller 200 to the cell controller 100 is performed, the battery controller 200 continuously transmits unmodulated carrier wave from the read/write circuit 210 via an antenna 250, as illustrated in FIG. 4. On the other hand, the cell controller 100 changes the impedance of the antenna 50 in accordance with a predetermined communication rate, in dependence on transmitted data in the modulator 42 in the RFID circuit 40. For example, an impedance matching circuit and a switch are provided in the modulator 42. The impedance is changed by switching the switch between a state in a case where a bit of the transmitted data is "1" and a state in a case where the bit of the transmitted data is "0" in order to control the connection state between the impedance matching circuit and the antenna 50. In this case, the above-described power source voltage Vdd, which is generated by the power supply circuit 31 on the basis of the electric power supplied from the battery cell in the corresponding cell group 10, is used as an operating power source of the switch.

Once the cell controller 100 receives unmodulated carrier wave transmitted from the battery controller 200 with the impedance of the antenna 50 being changed in the aforementioned way, a reflective wave depending on the state of the impedance at the time is transmitted from the antenna 50. In other words, if the unmodulated carrier wave from the battery controller 200 is received in an impedance-matched state, the reflective wave is not transmitted because the unmodulated carrier wave is totally absorbed in the antenna 50. On the other hand, if the unmodulated carrier wave from the battery controller 200 is received in an impedance-mismatched state, a part of the unmodulated carrier wave is transmitted from the antenna 50 as the reflective wave. In this way, the wireless communication from the cell controller 100 to the battery controller 200 can be performed by changing the reflective wave for the unmodulated carrier wave from the battery controller 200 in dependence on the transmitted data.

The communication distance in the wireless communication scheme of the present invention will now be described. In the conventional passive and inductive-coupled RFID, it is necessary to perform wireless communication from the RFID to a reader by using a received electric power of a wireless signal transmitted from the reader. The communication distance in this case is generally of the order of several centimeters.

On the contrary, in the wireless communication scheme of the present invention, the impedance of the antenna 50 is changed in each cell controller 100 by using the electric power supplied from the battery cells in the corresponding cell group 10, as described above. In this way, the semi-passive wireless communication utilizing the reflective wave for the unmodulated carrier wave is performed.

Generally, a propagation loss L (dB) of the wireless signal in a free space can be represented by the following equation (1). In the equation (1), d(m) denotes a distance between antennas and λ(m) denotes a wavelength of the wireless signal.

$$L = 20\log(4\pi d/\lambda) \ldots (1)$$

It is here assumed that a transmission electric power in the read/write circuit 210 of the battery controller 200, which is the reader, is 1 W (30 dBm) and the minimum receiving sensitivity is -80 dBm. In this case, it is possible to perform wireless communication from the cell controller 100 to the battery controller 200 with a round-trip propagation loss in a range of 110 dB or less. In other words, the communication distance is a range corresponding to the propagation loss L=55 dB.

For example, given that the frequency of the wireless signal is 900 MHz (λ=0.33 m), it is found that the communication distance is d=14.9 m for L=55 dB in the forgoing equation (1). Therefore, it is found that the communication distance can be extended in the semi-passive wireless communication according to the present invention, in comparison to the conventional passive wireless communication as described above.

In accordance with the first embodiment of the present invention described above, the following beneficial operational effects are obtained.

(1) In the battery system 1, each cell controller 100 uses the electric power supplied from the battery cells in the corresponding cell group 10 to wirelessly transmit measurement result of the state of each battery cell in the cell groups 10 to the battery controller 200. Thus, the communication distance can be extended in the battery system 1 that transmits the state of each battery cell by wireless communication.

(2) The battery controller 200 continuously transmits the unmodulated carrier wave to each cell controller 100. Then, each cell controller 100 changes the impedance for the unmodulated carrier wave transmitted from the battery controller 200 at a predetermined timing in dependence on the measurement result of the state of each battery cell in the respective cell groups 10. As a result, the cell controller 10 wirelessly transmits the measurement result of the state of each battery cell in the cell groups 10 to the battery controller 200. Thus, the communication distance can be extended, while power consumption in each cell controller 100 is suppressed.

(3) Each cell controller 100 includes the sensor 20 and the AD converter 32 which constitute the measurement circuit for measuring the state of each battery cell in the respective cell groups 10, and the cell controller 100 further includes the power supply circuit 31, the antenna 50, and the RFID circuit 40. The RFID circuit 40 changes the impedance of the antenna 50 in accordance with the state of each battery cell in the cell groups 10 measured by the sensor 20 and the AD converter 32, by using the power source voltage Vdd generated by the power supply circuit 31. Thus, in each cell controller 100, the state of each battery cell in the respective cell groups 10 can be reliably measured and the measurement result can be transmitted to the battery controller 200.

(4) The battery controller 200 performs wireless communication with the host controller 300 by means of a wireless scheme of the wireless communication different from the wireless communication with each cell controller 100. Thus, wiring between the battery controller 200 and the host controller 300 may be omitted, which results in additional cost reduction.

(Second Embodiment)

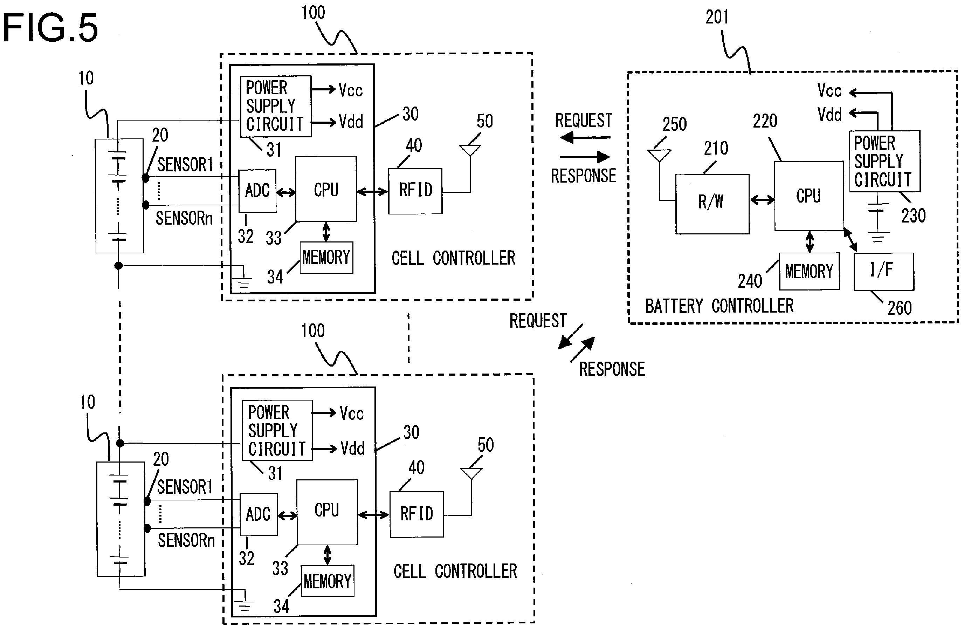

FIG. 5 is a basic configuration figure of a battery system in accordance with a second embodiment of the present invention. The battery system in this embodiment is adapted to be provided in the in-vehicle system illustrated in FIG. 1, in the same manner as the battery system 1 described in the first embodiment. This battery system is different from the battery system 1 described in the first embodiment in that it has a battery controller 201 in place of the battery controller 200 in FIG. 2. In FIG. 5, the host controller 300 is omitted.

The battery controller 201 is provided with an interface circuit 260 for wired communicating with the host controller 300, in addition to the same components as those in the battery controller 200 in FIG. 2. This interface circuit 260 is used to connect the battery controller 210 to the host controller 300 via a communication cable so that required data can be transmitted and received between the battery controller 201 and the host controller 300.

It will be noted that the read/write circuit 210 may not have the low power wireless communication function in the battery controller 201 of this embodiment, in contrast to the first embodiment described above. In other words, in this embodiment, it is only necessary for the read/write circuit 210 to have the wireless communication function with the semi-passive RFID in order to perform wireless communication with each cell controller 100.

In accordance with the second embodiment of the present invention described above, the battery controller 201 includes the interface circuit 260 for wired communicating with the host controller 300. Thus, the low power wireless communication function of the read/write circuit 210 may be omitted in the battery controller 201, which results in cost reduction.

(Third Embodiment)

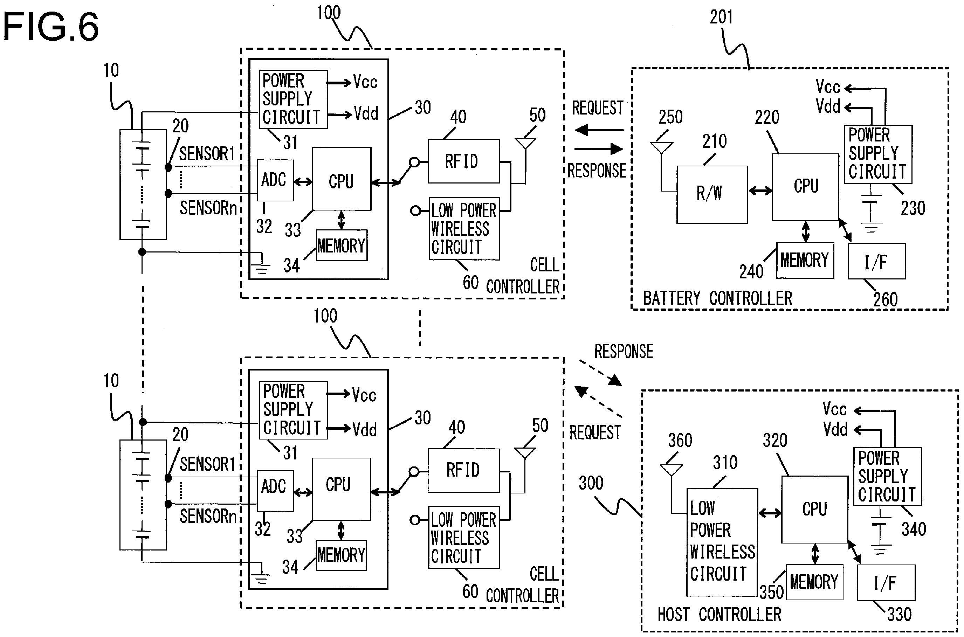

FIG. 6 is a basic configuration figure of a battery system in accordance with a third embodiment of the present invention. The battery system in this embodiment is adapted to be provided in the in-vehicle system illustrated in FIG. 1, in the same manner as the battery system 1 described in the first embodiment. This battery system is different from the battery system 1 described in the first embodiment in that it has a cell controller 101 in place of the cell controller 100 in FIG. 2 and it has the same battery controller 201 as that in the second embodiment described above.

Each cell controller 101 is provided with a low power wireless circuit 60, in addition to the same components as those in the cell controller 100 in FIG. 2. In each cell controller 101, the connecting partner of the CPU 33 is switched between the RFID circuit 40 and the low power wireless circuit 60 by controlling the CPU 33. With this switching operation, each cell controller 101 can select either the RFID circuit 40 or the low power wireless circuit 60 and perform wireless communication using the selected circuit.

If the RFID circuit 40 is selected, each cell controller 101 can perform the semi-passive wireless communication with the battery controller 201, as described in the first embodiment. On the other hand, if the low power wireless circuit 60 is selected, each cell controller 101 can perform the low power wireless type of wireless communication with the host controller 300. The determination of which wireless communication function is used may be based on predetermined setting conditions or the like, or the determination may be made in accordance with instructions from the battery controller 201 or the host controller 300. For example, if the RFID circuit 40 or the low power communication circuit 60 is selected depending on setting values stored in a predetermined storage area in the memory 34, the switching operation as described above can be performed by rewriting the setting values. Alternatively, it may be determined whether the wireless signal is transmitted from the battery controller 201 or the host controller 300 on the basis of the frequency or the field strength of the wireless signal received in each cell controller 101 in order to perform the switching operation in accordance with the determination result.

In accordance with the third embodiment of the present invention described above, each cell controller 101 includes the low power wireless circuit 60 for wireless communication with the host controller 300. Thus, wireless communication can be performed between each cell controller 101 and the host controller 300, not via the battery controller 201. Therefore, a processing load of the battery controller 201 is reduced, while the wireless communication can be performed even in case of failure of the battery controller 201.

It will be noted that the timing of transmitting the measurement information from the cell controller 100 or 101 to the battery controller 200 or 201 or to the host controller 300 may vary in the embodiments described above. For example, if the measurement information is within a normal range, the measurement information is transmitted every one second. On the other hand, if the measurement information is out of the normal range, the measurement information is transmitted every 0.1 seconds. In this way, any occurrence of over-charging or over-discharging in each battery cell can be immediately detected, while power consumption during the normal operation can be reduced.

Although the application examples has been explained with respect to the battery system included in the in-vehicle system in FIG. 1 in the embodiments described above, the present invention may also be applied to other battery systems. For example, the present invention is applicable to a battery system that is not yet mounted on a vehicle, but stored in a warehouse or the like. In this case, the battery controller 200 or each cell controller 101 may be adapted to perform wireless communication with devices used for inventory management or shipment inspection, for example, instead of with the host controller 300. Thus, the device can more readily obtain the state of each battery cell in a battery system to be managed or to be examined, by wireless communication. Therefore, a management man-hour and an inspection man-hour decrease, and, if a failure occurs in any battery cell, such battery cell can be readily identified.

REFERENCE SIGNS LIST

```
10 ... cell group
20 ... sensor
30 ... processing unit
31 ... power supply circuit
32 ... AD converter
33 ... CPU
34 ... memory
40 ... RFID circuit
41 ... demodulator
42 ... modulator
50 ... antenna
60 ... low power wireless circuit
100, 101 ... cell controller
200, 201 ... battery controller
210 ... read/write circuit
220 ... CPU
230 ... power supply circuit
240 ... memory
250 ... antenna
260 ... interface circuit
300 ... host controller
310 ... low power wireless circuit
320 ... CPU
330 ... interface circuit
340 ... power supply circuit
350 ... memory
360 ... antenna
```

**Claims**

**1.** A battery system, comprising:

cell groups (10), each of which being constructed of single or a plurality of battery cells; cell controllers (100, 101) installed to each cell group (10); and a battery controller (200, 201) that communicates with the cell controllers (100, 101) to obtain states of the battery cells from the cell controllers (100, 101), wherein:

each of the cell controllers (100, 101) comprises:

a measurement circuit that measures the states of the battery cells constituting the corresponding cell group (10); a power supply circuit (31, 340) that is powered by the battery cells constituting the corresponding cell group (10) to generate a power source voltage; an antenna (360) that transmits and receives wireless signals; and a wireless communication circuit that is supplied with the power source voltage from the power supply circuit (31, 340) for activation to generate wireless signals for the states of the battery cells measured by the measurement circuit as wireless signals to be transmitted via the antenna (360) and to process wireless signals from the battery controller (200, 201) received via the antenna (360); and the battery controller (200, 201) receives the wireless signals transmitted from the cell controllers (100, 101) to obtain the states of the battery cells measured by each of the measurement circuits, **characterized in that**, the battery controller (200, 201) continuously transmits unmodulated carrier wave to each of the cell controllers (100, 101); and each of the wireless communication circuit changes an impedance for the unmodulated carrier wave transmitted from the battery controller (200, 201) at a predetermined timing in dependence on the states of the battery cells measured by the measurement circuit so as to transmit the wireless signal for the states of the battery cells measured by the measurement circuit to the battery controller (200, 201).

**2.** The battery system according to claim 1, wherein:

each of the cell controllers (100, 101) changes the impedance for the unmodulated carrier wave transmitted from the battery controller (200, 201), by using the power supply voltage from the power supply circuit (340).

## Patentansprüche

1. Batteriesystem, das Folgendes umfasst:

Zellengruppen (10), die jeweils aus einer oder aus mehreren Batteriezellen aufgebaut sind;
Zellensteuereinheiten (100, 101), die bei jeder Zellengruppe (10) installiert sind; und
eine Batteriesteuereinheit (200, 201), die mit den Zellensteuereinheiten (100, 101) kommuniziert, um Zustände der Batteriezellen von den Zellensteuereinheiten (100, 101) zu erhalten, wobei:

jede der Zellensteuereinheiten (100, 101) Folgendes umfasst:

eine Messschaltung, die die Zustände der die entsprechende Zellengruppe (10) bildenden Batteriezellen misst;
eine Leistungsversorgungsschaltung (31, 340), die von den die entsprechende Zellengruppe (10) bildenden Batteriezellen mit Leistung versorgt wird, um eine Versorgungsspannung zu erzeugen;
eine Antenne (360), die drahtlose Signale überträgt und empfängt; und
eine drahtlose Kommunikationsschaltung, die zur Aktivierung mit der Versorgungsspannung aus der Leistungsversorgungsschaltung (31, 340) versorgt wird, um drahtlose Signale für die von der Messschaltung gemessenen Zustände der Batteriezellen als mittels der Antenne (360) zu übertragende drahtlose Signale zu erzeugen und von der Batteriesteuereinheit (200, 201) über die Antenne (360) empfangene drahtlose Signale zu verarbeiten; und
wobei die Batteriesteuereinheit (200, 201) die von den Zellensteuereinheiten (100, 101) übertragenen drahtlosen Signale empfängt, um die von jeder der Messschaltungen gemessenen Zustände der Batteriezellen zu erhalten, **dadurch gekennzeichnet, dass**
die Batteriesteuereinheit (200, 201) kontinuierlich eine nicht modulierte Trägerwelle zu jeder der Zellensteuereinheiten (100, 101) überträgt; und
jede der drahtlosen Kommunikationsschaltungen eine Impedanz für die von der Batteriesteuereinheit (200, 201) übertragene nicht modulierte Trägerwelle zu einem vorgegebenen Zeitpunkt in Abhängigkeit von den von der Messschaltung gemessenen Zuständen der Batteriezellen verändert, um das drahtlose Signal für die mittels der Messschaltung gemessenen Zustände der Batteriezellen zu der Batteriesteuereinheit (200, 201) zu übertragen.

2. Batteriesystem nach Anspruch 1, wobei:

jede der Zellensteuereinheiten (100, 101) die Impedanz für die von der Batteriesteuereinheit (200, 201) übertragene nicht modulierte Trägerwelle unter Verwendung der Versorgungsspannung von der Leistungsversorgungsschaltung (340) verändert.

## Revendications

1. Système de batterie, comprenant :

des groupes de cellules (10), dont chacun est construit d'une unique ou d'une pluralité de cellules de batterie ;
des contrôleurs de cellules (100, 101) installés pour chaque groupe de cellules (10) ; et
un contrôleur de batterie (200, 201) qui communique avec les contrôleurs de cellules (100, 101) pour obtenir des états des cellules de batterie depuis les contrôleurs de cellules (100, 101), dans lequel :

chacun des contrôleurs de cellules (100, 101) comprend :

un circuit de mesure qui mesure les états des cellules de batterie constituant le groupe de cellules correspondant (10) ;
un circuit d'alimentation de puissance (31, 340) qui est alimenté par les cellules de batterie constituant le groupe de cellules correspondant (10) pour générer une tension de source de puissance ;
une antenne (360) qui émet et qui reçoit des signaux sans fil ; et
un circuit de communication sans fil qui est alimenté avec la tension de source de puissance provenant du circuit d'alimentation de puissance (31, 340) pour une activation afin de générer des signaux sans fil pour les états des cellules de batterie mesurés par le circuit de mesure sous forme de signaux sans fil destinés à être émis via l'antenne (360) et de traiter des signaux sans fil provenant du contrôleur de batterie (200, 201) reçus via l'antenne (360) ; et le contrôleur de batterie (200, 201) reçoit les signaux sans fil émis depuis les contrôleurs de cellules (100, 101) pour obtenir les états des cellules de batterie mesurés par chacun des circuits de mesure,

**caractérisé en ce que**

le contrôleur de batterie (200, 201) émet en continu une onde porteuse non modulée vers chacun des contrôleurs de cellules (100, 101), et chacun des circuits de communication sans fil change une impédance pour l'onde porteuse non modulée émise depuis le contrôleur de batterie (200, 201) à une temporisation prédéterminée en dépendance des états des cellules de batterie mesurés par le circuit de mesure de manière à émettre le signal sans fil pour les états des cellules de batterie mesurés par le circuit de mesure vers le contrôleur de batterie (200, 201).

2.  Système de batterie selon la revendication 1, dans lequel :

chacun des contrôleurs de cellules (100, 101) change l'impédance pour l'onde porteuse non modulée émise depuis le contrôleur de batterie (200, 201), en utilisant la tension d'alimentation de puissance provenant du circuit d'alimentation de puissance (340).

# FIG.1

BATTERY SYSTEM

1

10

CELL GROUP

10

CELL GROUP

100

CELL CONTROLLER

CELL CONTROLLER

100

200

BATTERY CONTROLLER

4

RELAY BOX

300

HOST CONTROLLER

2

INVERTER

3

MOTOR

EP 2 980 912 B1

# FIG.2

EP 2 980 912 B1

# FIG.3

EP 2 980 912 B1

# FIG.4

EP 2 980 912 B1

# FIG.5

REQUEST

RESPONSE

REQUEST

RESPONSE

EP 2 980 912 B1

# FIG.6

EP 2 980 912 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2007182576 A1
- WO 2012061262 A1
- EP 1769426 A2
- JP 2005135762 A